Europäisches Patentamt

European Patent Office

Office européen des brevets

(11) Publication number: **0 242 864 B1**

(12) **EUROPEAN PATENT SPECIFICATION**

(45) Date of publication of patent specification: **08.07.92**  (51) Int. Cl.⁵: **G03F 7/09**, G03C 1/72, B41C 1/10

(21) Application number: **87105886.3**

(22) Date of filing: **22.04.87**

(54) **A process for making a lithographic printing plate.**

(30) Priority: **23.04.86 JP 93532/86**

(43) Date of publication of application:
**28.10.87 Bulletin 87/44**

(45) Publication of the grant of the patent:
**08.07.92 Bulletin 92/28**

(84) Designated Contracting States:
**DE FR GB**

(56) References cited:
**EP-A- 0 109 838**
**WO-A-85/00670**
**FR-A- 2 108 292**
**US-A- 4 489 151**

**PATENT ABSTRACTS OF JAPAN, vol. 8, no. 80 (M-289)[1517], 12th April 1984 & JP-A-58 224 752**

**PATENT ABSTRACTS OF JAPAN, vol. 8, no. 87 (M-291)[1524], 20th April 1984 & JP-A-59 2845**

**PATENT ABSTRACTS OF JAPAN, vol. 9, no. 29 (M-356)[1752], 7th February 1985 & JP-**

**A-59 174 394**

(73) Proprietor: **FUJI PHOTO FILM CO., LTD.**
**210 Nakanuma Minami Ashigara-shi Kanagawa 250-01(JP)**

(72) Inventor: **Hasegawa, Akira**
**c/o Fuji Photo Film Co., Ltd. 4000, Kawashiri Yoshida-cho Haibara-gun Shizuoka-ken(JP)**

(74) Representative: **Patentanwälte Grünecker, Kinkeldey, Stockmair & Partner Maximilianstrasse 58 W-8000 München 22(DE)**

Rank Xerox (UK) Business Services

# Description

## BACKGROUND OF THE INVENTION

### Field of the Invention

The present invention relates to a process for making a lithographic printing plate, more specifically to a process for making a lithographic printing plate by dry treatment.

### Description of the Prior Art

In the so-called light printing field, various printing methods have been utilized, and recently lithographic printing methods, which give excellent image quality, printing durability and the like, have come to be widely utilized. Especially useful methods for making a lithographic printing plate are direct plate making methods where a printing plate is made by directly printing out a manuscript through lens optics system, etc. However, direct plate making method which have hitherto been practically used, generally have undesirable aspects that a wet developing process is contained therein, large-sized apparatuses are used, care of the developing solution is troublesome, and the like. Thus, simple processes for making lithographic printing plate have hitherto been proposed. Japanese Published Unexamined Patent Application No. 2845/1984 discloses a process for making a lithographic printing plate which comprises providing on a water resistant support a layer which contains photohardenable type microcapsules each of which mainly contains a photohardenable resin, printing the surface of the layer by pressurization, and then exposing the whole surface of the layer. Particle size of the microcapsules used in this process is necessary to be several microns or more. However, large particle size of the microcapsules lowers pattern-resolving power of the presensitized plate from which a lithographic printing plate is to be made. Further, there is a fear that large-sized microcapsules are liable to be destroyed in handling of the presensitized plate and thus are a cause of background contamination.

Japanese Published Unexamined Patent Application No. 174394/1984 discloses a process for making a lithographic printing plate which comprises thermally printing a presensitized plate comprising a water resistant support having provided thereon a layer comprising a heat fusible substance having a melting point of 60 to 180°C and a particle size of 0.1 to 10 microns, and a hydrophilic binder. However, the intensity of images obtained using a lithographic printing plate made according to this process is weak, and printing durability of the lithographic printing plate is insufficient.

## SUMMARY OF THE INVENTION

An object of the present invention is to provide a simple process for making a lithographic printing plate having image areas of high printing durability and nonimage areas which do not cause background contamination, from a presensitized plate of high resolving power.

The object of the present invention can be attained by a process for making a lithographic printing plate which comprises applying on a support a layer containing microcapsules which contain a photopolymerizable monomer and/or light-sensitive resin, and thermally printing the surface of the applied layer as defined in claim 1.

The process of the present invention for making a lithographic printing plate utilizes the fact that the wall of the microcapsules which has a thermosoftening property and/or contents of the microcapsules such as a photopolymerizable monomer and light-sensitive resin are mixed with heating to form a lipophilic uniform membrane.

## DETAILED EXPLANATION OF THE INVENTION

Microcapsules, as used in the present invention, which mainly contain a photopolymerizable monomer and/or light-sensitive resin, are stable under ordinal handling thereof and under ordinal conditions, but have a thermosoftening temperature and thermal transmission coefficient depending on material of the microcapsule wall. The characteristic of the present invention lies in applying microcapsules with such properties on a support, thermally printing the surface of the applied layer with a thermal head whereby microcapsule walls at the printing area and/or the contents of the microcapsules such as a photopolymerizable monomer and light-sensitive resin are thermally fused to form a lipophilic uniform membrane, and thereby obtaining a lithographic printing plate. Further, though it is possible to make image areas having intensity durable enough for printing only by thermal printing, to expose the whole surface of the applied layer after the thermal printing in order enhances film strength and printing durability of the image areas.

A light source used for the exposure includes, for example, mercury lamps, metal halide lamps, xenon lamps, chemical lamps, carbon arc lamps and the like. Further, scanning exposure using an high density energy beam (a laser beam or electron beam) may also be used in the present invention. Such laser beams include helium-neon laser, argon laser, krypton laser, helium-cadmium laser and the like.

The polymerizable monomer used in the present invention is a compound having one or preferably plural vinyl or vinylidene groups, and includes compounds having, for example, an acryloyl group, methacryloyl group, allyl group, unsaturated polyester group, vinyloxy group, acrylamido group, and the like.

Most typical photo-polymerizable monomers used in the present invention and a reaction product of a polyol, polyamine or aminoalcohol, etc. with an unsaturated carboxylic acid, a reaction product of an acrylate or methacrylate having a hydroxyl group with a polyisocyanate. Typical examples of such compounds are, for example, polyethylene glycol diacrylate, propylene glycol dimethacrylate, pentaerythritol triacrylate, trimethylolpropane triacrylate, pentaerythritol tetraacrylate, hexanediol diacrylate, l,2-butanediol diacrylate, tetrakis($\beta$-acryloxyethyl)ethylenediamine, a reaction product of an epoxy resin with acrylic acid, a reaction product of methacrylic acid, pentaerythritol and acrylic acid; a condensate of maleic acid, diethylene glycol and acrylic acid; methyl methacrylate, butyl methacrylate, styrene, divinylbenzene, diallylnaphthalene, and the like. Polymerizable monomers usable in the present invention may further be selected from those disclosed in Japanese Published Unexamined Patent Application Nos. 52889/l974, 6864l/l973 and 32586/l973, Japanese Published Examined Patent Application No. 7ll5/l974 and the like. These monomers may be used alone or in combination according to the desired purpose.

In general, these monomers absorb light at 300 nm or less in the ultraviolet region. Therefore, it is desirable to simultaneously use a light-sensitive material, in order to impart light sensitivity to the light in the ultraviolet to visible region to a light-sensitive layer, which absorbs light in such region and causes polymerization of monomers. Examples of the light-sensitive material include compounds which are generally known as photopolymerization initiators and already disclosed in detail in, for instance, Kosar, "Light Sensitive Systems", John Wiley & Sons; Warashina et al., "Light-sensitive Resins" issued by Nikkan Kogyo Shinbunsha (newspaper publishing company); Kakuta et al., "Light-sensitive Resins", the Print Society.

The photopolymerization initiators are, for example, aromatic ketones, quinone compounds, ether compounds and nitro compounds. Examples thereof are benzoquinone, phenanthrenequinone, naphthoquinone, diisopropylphenanthrenequinone, benzoisobutyl ether, benzoin, furoinbutyl ether, Michler's ketone, Michler's thioketone, tetraphenyl furoin dimer, fluorenone, trinitrofluorene, $\beta$-benzoylaminonaphthalene. These initiators are used in an amount of 0.l to 30% by weight based on the weight of vinyl compounds in the present invention.

Moreover a polymer as disclosed in Japanese Patent Application No. l5l864/l985 and Japanese Published Examined Patent Application Nos. 327l4/l97l and 3404l/l974 may be encapsulated in the microcapsule in order to make the hardening by photopolymerization more effective.

According to the present invention, the foregoing photopolymerizable monomer, photopolymerization initiator, light-sensitive resin or the like are then encapsulated into microcapsules. At this stage, a solvent may simultaneously be used, which may be a natural or synthetic oil which can be used alone or in combination. Examples of such solvents include cottonseed oil, kerosine, aliphatic ketone, aliphatic ester, paraffin, naphthene oil, alkylated biphenyl, alkylated terphenyl, chlorinated paraffin, alkylated naphthalene, and a diaryl ethane such as l-phenyl-l-xylylethane, l-phenyl-l-p-ethylphenyl ethane, l,l'-ditolylethane.

The light-sensitive resins as used herein are, for instance, a cinnamate of polyvinyl alcohol; a light-sensitive resin comprising an azide compound and a cyclized rubber, or a styrene-butadiene copolymer; a diazo light-sensitive resin; a light-sensitive resin comprised of polyvinyl acetophenone and benzaldehyde.

In addition to the aforementioned compounds, the microcapsule according to the present invention may include a thermal polymerization inhibitor. Useful examples thereof include hydroquinone, p-methoxyphenol, di-tert-butyl-p-cresol, pyrogallol, tert-buthyl catechol, benzoquinone, 4,4'-thiobis(3-methyl-6-tert-butylphenol), 2,2'-methylene-bis(4-methyl-6-tert-butylphenol), and 2-mercaptobenzimidazole. Moreover, the microcapsule may contain a dye or a pigment for the purposes of coloring the resulting light-sensitive layer and further a pH indicator as the printing-out agent and a dye as disclosed in Japanese Published Unexamined Patent Application No. l20354/l985.

For the purpose of the coloration of image areas, it may also be effective to encapsulate, into the microcapsule, either a coloring agent or a combination of a coloring agent and a color precursor which permits the formation of a colored material when it comes into contact with the coloring agent. The term "coloring agent" herein means a material capable of coloring because of the donation of an electron to other materials or receiving a proton from a proton-donor such as an acid. These coloring agents which may be used in the present invention are not restricted to specific compounds and in general they include compounds which are usually colorless and have a partial skeleton of for instance lactone, lactam, sultone, spiro pyran, ester or amide, the partial skeleton being cleaved or splitted when coming it into contact with a color precursor. Examples thereof are, for instance, Crystal Violet lactone, benzoyl leuco Methylene Blue, Malachite Green lactone, rhodamine β-lactam, l,3,3-trimethyl-6'-ethyl-8'-butoxyindolinobenzospiro pyran.

As color precursors for these coloring agent, there may be mentioned, for instance, phenol compounds, organic acids or metal salts thereof, oxybenzoates and clay. In particular, the developer desirably used in the present invention includes phenols and organic acids hardly soluble in water having a melting point of from 50 to 250°C, particularly preferred range thereof being from 60 to 200°C.

Such phenol compounds include, for instance, 4,4'-isopropylidenediphenol (ie., bisphenol A); p-tert-butylphenol; 2,4-dinitrophenol; 3,4-dichlorophenol; 4,4'-methylenebis(2,6-di-tert-butyl-phenol); p-phenylphenol; 4,4'-cyclohexylidenediphenol; 2,2'-methylenebis(4-tert-butyl-phenol); 2,2'-methylenebis (α-phenyl-p-cresol)-thiodiphenol; 4,4'-thiobis(6-tert-butyl-m-cresol); sulfonyldiphenol; l,l-bis(4-hydroxyphenyl)-n-dodecane; 4,4-bis-(4-hydroxyphenyl)-l-pentanoic acid ethyl ester; p-tert-butylphenol-formalin condensate and p-phenylphenol-formalin condensate.

Useful examples of the organic acids include 3-tert-butylsalicylic acid, 3,5-tert-butylsalicylic acid, 5-α-methylbenzylsalicylic acid, 3,5-di-α-methylbenzylsalicylic acid, 3-tert-octylsalicylic acid, 5-α,γ-dimethyl-α-phenyl-γ-phenylpropylsalicylic acid.

As the oxybenzoic acid ester, there may be mentioned, for example, ethyl p-oxybenzoate, butyl p-oxybenzoate, heptyl p-oxybenzoate and benzyl p-oxybenzoate.

The photohardenable microcapsule according to the present invention may contain a foaming agent for the purpose of effectively the collapsing the microcapsule to release the content thereof during heating.

In the present invention, nitroso type compounds, sulfohydrazido type compounds which are hydrazine derivatives of organo sulfonic acids, hydrazo compounds and azo compounds may be used as such foaming agent.

Examples of the nitroso type compounds include dinitrosopentamethylenetetramine, N,N'-dimethyl-N,N'-dinitrosoterephthalamide and trinitrosotrimethylenetriamine.

As the sulfohydrazide type compounds, there may be mentioned, p-toluenesulfohydrazide, benzenesulfohydrazide, p,p'-oxybis-(benzenesulfohydrazide), benzene-l,3-disulfohydrazide, 3,3'-disulfohydrazidephenyl sulfone, toluene-2,4-disulfohydrazide, and p-p'-thiobis-(benzenesulfohydrazide).

Examples of the hydrazo compounds include, for instance, hydrazodicarbamide, N,N'-dibenzoylhydrazine, β-acetylphenylhydrazine, biurea and l,l-diphenylhydrazine.

As the azo compounds there may be mentioned, for example, azobisisobutyronitrile, azodicarbonamide(azobisformamide), diazoaminobenzene and azocarboxylic acid diethyl ester (diethyl azodicarboxylate).

These organic foaming agents are all decomposed by heating and generate nitrogen gas. Although some compounds generate a small amount of carbon monooxide, carbon dioxide and water vapour in addition to nitrogen gas, at least 60% of the total gas generated is composed of nitrogen gas. The amount of gases generated, in general, falls within the range of from l00 to 300 ml/g.

The foaming agent is used in an amount of 0.l to 20% by weight based on the capsule.

The thermal decomposition temperature of these organic foaming agents falls within the range of from about 80 to about 300°C. In this respect, an auxiliary agent for thermal decomposition may also be used in the present invention to lower the decomposition temperature of the organic foaming agent. Examples of effective auxiliary agent for thermal decomposition include, urea and derivatives thereof, zinc white (zinc oxide), lead carbonate, lead stearate and glycolic acid.

Preferred examples of the auxiliary agent for thermal decomposition are urea and the derivatives thereof such as ethanolamine urea, guanylurea and aminoguanidine carbonate. The auxiliary agent for thermal decomposition is preferably used in an amount of about 30 to 60% by weight based on the organic foaming agent.

It is believed that the decomposition temeprature of chemically pure azodicarbonamide is 230°C. The decomposition temperature thereof can be lowered to about l20°C by the addition of a variety of auxiliary agents for thermal decomposition.

The microcapsule as used in the present invention may be produced according to a conventional method well known in the art. As to the process for preparing microcapsules, reference is made to, for example, U.S. Patent Nos. 2,800,457 and 2,800,458 in which a method utilizing coacervation of a material forming a hydrophilic wall is disclosed; U.S. Patent No. 3,287,l54, British Patent No. 990,443 and Japanese Published Examined Patent Application Nos. l9574/l963, 446/l967 and 7ll/l967 in which microcapsules are prepared according to an interfacial polymerization technique; U.S. Patent Nos. 3,4l8,250 and 3,660,304 which disclose a method for preparing microcapsules by separating out polymers; U.S. Patent No. 3,796,669 which discloses a method utilizing a wall-forming material of isocyanate-polyol; U.S. Patent No. 3,9l4,5ll in which an isocyanate is used as the wall-forming material; U.S. Patent Nos. 4,00l,l40, 4,087,376 and 4,089,802 which disclose a method using an urea-formaldehyde type or urea-formaldehyde-resorcinol type wall-forming material; U.S. Patent No. 4,025,455 disclosing a method in which melamine-formaldehyde resin, hydroxypropyl cellulose or the like is utilized as a wall-forming material; Japanese Published Examined Patent Application No. 9163/1961 and Japanese Published Unexamined Patent Application No. 9079/1976 disclosing a method in which microcapsules are produced, in situ, by polymerizing monomers; British Patent Nos. 952,807 and 965,074 disclosing an electrolytic dispersion and cooling process; and U.S. Patent No. 3,111,407 and British Patent No. 930,422 disclosing a spray drying method. The present invention is not restricted to the aforementioned methods. However, it is preferred that the microcapsule is produced by emulsifying core materials before forming a polymeric membrane as the wall thereof.

Specific examples of polymeric material usable as microcapsule wall are polyurethanes, polyureas, polyamides, polyesters, polycarbonates, urea-formaldehyde resins, melamine resins, polystyrene, styrene-methacrylate copolymers, styrene-acrylate copolymers, gelatin, polyvinyl pyrrolidone and polyvinyl alcohols.

There polymeric materials may be used alone or in combination. Preferred polymeric materials are polyurethanes, polyureas, polyamides, polyesters and polycarbonates, especially polyurethanes and polyureas. It is preferred to adjust particle sizes of the microcapsules to from 0.01 to 30$\mu$, especially from 0.01 to 10$\mu$ in view of handling properties, above all from 0.01 to 5$\mu$ in view of pattern-resolving power.

In preparing microcapsules, a water soluble polymer and/or a surfactant may be used. The water soluble polymers used herein include anionic polymers, nonionic polymers and amphoteric polymers.

The anionic polymer may be a natural or a synthetic one having, for instance, groups such as -COO$^-$ and -SO$_3$$^-$. As the natural anionic polymer, there may be mentioned, for example, gum arabic, alginic acid; as the semisynthetic anionic polymer there may be mentioned, for instance, carboxymethylcellulose, phthalated gelatin, sulfated starch, sulfated cellulose and lignin sulfonic acid; and the synthetic anionic polymers include maleic anhydride type copolymers (inclusive of those hydrolyzed), (meth)acrylic acid type polymers and copolymers, vinylbenzenesulfonic acid type polymers and copolymers, and carboxylated polyvinyl alcohols.

Examples of the amphoteric polymer include gelatin.

As the surfactant, there may be mentioned, for instance, nonionic surfactants such as polyoxyethylene alkyl ethers, polyoxyethylene alkyl phenyl ethers, polyoxyethylene fatty acid esters, sorbitan fatty acid esters, polyoxyethylene sorbitan fatty acid esters and glycerin fatty acid esters; anionic surfactants such as fatty acid salts, salts of alkylsulfates, alkylbenzenesulfonic acid salts, alkylnaphthalenesulfonic acid salts, salts of dialkyl sulfosuccinates, salts of alkyl phosphates, condensates of naphthalene sulfonic acid and formalin, and salts of polyoxyethylene alkylsulfates; cationic surfactants such as alkylamine salts, quaternary ammonium salts and polyoxyethylene alkylamine salts; and fluorine-containing surfactants. These surfactants or dispersion stabilizers may be used alone or in combination.

To emulsify or disperse the aforementioned ingredients, an apparatus for emulsifying is in general used. Preferred examples thereof are those capable of imparting a great shearing force to a liquid to be treated or those capable of applying ultrasonic energy thereto and, in particular, include a colloid mill, a homogenizer, a capillary-tube type emulsifying apparatus, a liquid siren, an electromagnetic striction type ultrasonic wave generator and an emulsifier provided with a Pollman tube, which can provide an excellent result.

According to the present invention, the microcapsule thus prepared is then applied to the surface of a support. When applying the microcapsule to a support, a binder is in general used, which may be used alone or in combination.

A hydrophilic binder is predominantly used and typical examples thereof are transparent or translucent hydrophilic binders which include natural materials such as gelatin, derivatives thereof, derivatives of cellulose (for example, carboxymethylcellulose and methylcellulose), and polysaccharides (for example, starch, and gum arabic); and synthetic polymeric materials, for example, water soluble polyvinyl compounds such as polyvinyl alcohol, polyvinyl pyrrolidone, acrylamide polymers, polyacrylic acid and vinyl acetate-acrylic acid copolymer.

The hydrophilic property of the nonimage areas of the lithographic printing plate of the present invention can be attained by a hydrophilic property of the hydrophilic capsule wall and/or hydrophilic binder as used, or can also be attained by a hydrophilic property of the hydrophilic support. Especially good results can be obtained when a hydrophilic property of the hydrophilic support is used, which is obtained by providing microcapsules and a hydrophilic binder on a support without strong adhesion, image-wise exposing, and removing the photohardened microcapsules and hydrophilic binder on a printing machine.

When hydrophilic property of a hydrophilic capsule wall and/or hydrophilic binder is utilized for giving nonimage areas a hydrophilic property, melamine-formaldehyde resin, urea-formaldehyde resin, glyoxal and other crosslinking agents can be added to the light-sensitive solution.

A support which can be used in the present invention includes paper; paper laminated with a plastic film such as polyethylene, polypropylene or polystyrene film; a metal plate such as aluminum, (inclusive of alloys thereof) zinc, iron or copper plate; sheet or film of plastics such as cellulose acetate, cellulose propionate, cellulose butyrate, polyethylene terephthalate, polyethylene, polystyrene, polypropylene, polycarbonate and polyvinyl acetal; and paper or a plastic film laminated with a metallic foil or deposited with a metal layer such as those listed above. The support may be subjected to surface roughening treatment, surface hydrophilizing treatment or the like according to need.

For example, an aluminum support is subjected to the following surface treatment. An aluminum is grained, for example, by an electrochemical graining method where an aluminum plate is grained by electrolyzing it in a hydrochloric acid or nitric acid electrolyte; or a mechanical graining method such as a wire brush graining method where an aluminum surface is scraped with a metal wire, a ball graining method where an aluminum surface is grained with an abrasive ball and an abrasive, and a brush graining method where an aluminum surface is grained with a nylon brush and an abrasive, alone or in combination.

The thus grained aluminum plate is then chemically etched with an acid or alkali. When an acid is used as an etching agent, it costs a very long time to destroy the fine structure and thus use of an acid therefor is disadvantageous for an industrial application, whereas use of an alkali as an etching agent improves such affairs.

An alkali agent preferably usable for these purposes includes sodium hydroxide, sodium carbonate, sodium aluminate, sodium metasilicate, sodium phosphate, potassium hydroxide, lithium hydroxide and the like. Preferred ranges of concentration of an alkali agent and temperature of etching are respectively I to 50 weight % and 20 to I00°C, and a condition where an amount of aluminum dissolved is 5 to 20 $g/m^2$ is preferable.

Acid washing is conducted after the alkali etching in order to remove smuts which remain on the surface of the aluminum plate. An acid used includes nitric acid, sulfuric acid, phosphoric acid, chromic acid, hydrofluoric acid, borofluoric acid and the like.

Further, removal of smuts formed by electrochemical roughening treatment of an aluminum plate is carried out preferably according to a method where the plate is contacted with sulfuric acid of a temperature of 50 to 90°C and a concentration of I5 to 65 weight % as disclosed in Japanese Published Unexamined Patent Application No. I2739/I978, or a method where the plate is etched with an alkali as disclosed in Japanese Published Examined Patent Application No. 28I23/I973.

The thus treated aluminum plate is usable as a support for application of the microcapsule, but in advance of it, the plate may also be subjected to a further treatment such as anodization and chemical treatment.

Anodization may be carried out according to a method which has hitherto been utilized. Specifically, an anodized film may be formed on an aluminum support surface by sending a direct or alternative current to the support in an aqueous or nonaqueous solution of sulfuric acid, phosphoric acid, chromic acid, oxalic acid, sulfamic acid, benzenesulfonic acid and the like alone or in combination.

Anodization conditions can not be determined wholesale as they variously vary depending on a kind of the electrolyte, but generally, an electrolyte concentration of I to 80 weight %, a solution temperature of 5 to 70°C, a current density of 0.5 to 60 amperes/$dm^2$, a voltage of I to I00 V and an electrolysis time of I0 to I00 seconds are preferred.

Among the above anodization methods, a method where anodization is conducted in sulfuric acid under a high current density as used in the invention disclosed in British Patent No. I,4I2,768, and a method where anodization is conducted using phosphoric acid as a electrolytic bath as disclosed in U.S. Patent No. 3,5II,66I are especially preferred.

The anodized aluminum plate may further be treated according to a method of dipping it in an aqueous alkali metal silicate such as sodium silicate solution as disclosed in U.S. Patent Nos. 2,7I4,066 and 3,I8I,46I, or provided with an undercoat of a hydrophilic cellulose such as conboxymethylcellulose containing a water soluble metal salt such as zinc acetate as disclosed in U.S. Patent No. 3,860,426.

A microcapsule solution to be coated on a support may contain various additives as hitherto been used in a recording system such as a binder, antioxidant, dispersing agent, antifoaming agent, pigment, dye and surfactant. These additives, and application methods and use methods thereof are well known and for example, disclosed in U.S. Patent Nos. 2,7II,375 and 3,625,736, British Patent No. I,232,347, Japanese Published Unexamined Patent Application Nos. 440I2/I975, 50II2/I975, I27718/I975 and 306I5/I975, U.S. Patent Nos. 3,836,383 and 3,846,33I and the like, and these methods are applicable to the present invention.

The thus obtained presensitized plate is thermally printed using a thermal printing apparatus such as a thermal printer, which is used as a station of a word processor, and a thermal facsimile to obtain image areas. Microcapsule walls of the thermally printed areas are softened, and the microcapsule walls and/or the contents of the microcapsules such as a photopolimerizable monomer are fused and mixed, whereby a lipophilic uniform film is formed. On the other hand, microcapsules in the nonimage areas exhibits a hydrophilic property as they are covered by a hydrophilic binder. When a hydrophilic support is used, a hydrophilic property due to the support can be utilized for giving a hydrophilic property to the nonimage areas.

The lithographic printing plate obtained by the present invention may further be subjected to a treatment for making the nonimage areas on the plate surface hydrophilic or a treatment for making the image areas lipophilic. As for the former treatment, a treating solution mainly containing at least one of a hydrophilic resin such as gum arabic, phosphate, aluminum alum and an acid, or a treating solution mainly containing a ferrocyanide or ferricyanide, and the like are generally used. As for the latter treatment, a treating solution mainly containing a polymer having a hydrophobic group or a metal salt thereof, etc. is generally used.

The following illustrates the examples of the present invention and the present invention should not be limited thereto.

Example I

(I) A support was made as follows.

The aluminum surface of a paper substrate of a thickness of $100\mu$ as laminated on the both surfaces with an aluminum foil of a thickness of $30\mu$ was treated as follows to make a support.

The surface of the aluminum-laminated paper was grained using a nylon brush and a suspension of pumices in water, and then well washed with water. The surface was then etched by immersing in 10% sodium hydroxide at 50°C for 60 seconds, washed with flowing water, neutralized and washed with 20% $HNO_3$, and washed with water. The resulting surface was anodized in 20% sulfuric acid under a current density of 2 A/dm² to make the thickness of anodic oxidation film to be 2.7 g/m². Then, the laminated paper was immersed in a 2.5% aqueous sodium silicate solution at 70°C for one minute, washed and dried.

(2) A light-sensitive solution was prepared as follows.

First, 5 g of 2,2-dimethoxy-2-phenylacetophenone was dissolved in 40 g of trimethylolpropane triacrylate, and then, I5 g of

TAKENATE DII0N (manufactured and sold by TAKEDA PHARMACEUTICALS Co. Ltd.) was dissolved therein followed by stirring to make an oil phase.

This oil phase was emulsified and dispersed in a 50 g of an aqueous 2% polyvinyl alcohol PVA-205 (manufactured and sold by KURARAY Co. Ltd.). Then, I0 g of a I.67% aqueous diethylenetriamine solution was added to the emulsion at room temperature with stirring, and the mixture was successively stirred. Thirty minutes thereafter, the temperature of the mixture was raised to 40°C, and the mixture was stirred for additional one hour and then cooled. An average particle size of the obtained microcapsules was $3.0\mu$.

(3) Then, I00 g of water and I g of white dextrin (manufactured and sold by NICHIDEN KAGAKU Co. Ltd.) were added to 50 g of the thus obtained microcapsule solution to obtain a light-sensitive solution. The solution was applied to the above aluminum support so that the applied weight after drying was 4.2 g/m² and the support was then dried to obtain a presensitized plate.

(4) The presensitized plate was thermally printed using a thermal facsimile, and subjected to whole surface exposure using ET 26 V UDNS ULTRA-PLUS FLIP-TOP PLATE MAKER (manufactured and sold by nuARC IND. INC.) to obtain a lithographic printing plate.

(5) The lithographic printing plate was then set on a HEIDELBERG GTO type printing machine and subjected to printing, whereby printing matters having no background contamination were obtained.

Example 2

(I) A light-sensitive solution was prepared as follows:

First, 30 g of trimethylolpropane triacrylate, 3 g of 2,2-dimethoxy-2-phenylacetophenone and I5 g of BURNOCK DN 950 (manufactaured and sold by DAINIPPON INK AND CHEMICALS Inc.) were mixed to make an oil phase.

The oil phase was emulsified and dispersed in a 2% aqueous methylcellulose solution. Then, I5 g of a I.I67% aqueous diethylenetriamine solution was added to the emulsion with stirring at room temperature, and the mixture was successively stirred. Thirty minutes thereafter, the temperature of the mixture was raised to 40°C, and the mixture was stirred for additional 30 minutes and then cooled. The average particle size of the thus obtained microcapsules was $2.4\mu$.

(2) The thus obtained microcapsule solution was applied to an aluminum support similar to that disclosed in Example I so that the applied weight after drying was 4.2 g/m$^2$ and the support was then dried to obtain a presensitized plate.

(3) The presensitized plate was thermally printed using a thermal facsimile, and then the microcapsule surface of the plate was subjected to whole surface exposure to obtain a lithographic printing plate.

## Claims

1. A process for making a lithographic printing plate which comprises the steps of:
applying on a hydrophilic surface of a support a layer containing microcapsules each comprising contents containing a photopolymerizable monomer and/or a light-sensitive resin, and a hydrophilic wall for encapsulating the contents,
thermally printing the surface of the applied layer whereby the microcapsule walls in the thermally printed areas are softened and the microcapsule walls and the contents are fused and mixed to form a lipophilic film in the thermally printed image areas and then
subjecting the surface of the applied layer to whole surface exposure whereby the photopolymerizable monomer and/or the light-sensitive resin contained in the microcapsules in non-image areas is polymerizable or hardened.

2. The process of claim 1, wherein said microcapsule-containing layer contains a binder.

3. The process of claim 2, wherein said binder is hydrophilic.

4. The process of claim 1, which comprises applying on a support a layer containing microcapsules which contain a photopolymerizable monomer and/or light-sensitive resin, and a hydrophilic binder, thermally printing the surface of the applied layer, subjecting the surface to whole surface exposure, and removing the layer which contains both the photohardened microcapsules and the hydrophilic binder on a printing machine.

5. The process of claim 1, wherein said photopolymeriazble monomer is a compound having at least one vinyl or vinylidene group selected from the group consisting of an acryloyl group, methacryloyl group, allyl group, unsaturated polyester group, vinyloxy group and acrylamido group.

6. The process of claim 1, wherein said microcapsules contain a photopolymerization initiator capable of absorbing light at ultraviolet to visible region and initiating the polymerization of the photopolymerizable monomer.

7. The process of claim 1, wherein said microcapsules further contain a coloring agent.

8. The process of clam 7, wherein said microcapsules further contain a color precursor.

9. The process of claim 1, wherein said microcapsules further contain an auxiliary agent for thermyl decomposition.

10. The process of claim 1, wherein the wall of said microcapsules is made of at least one member selected from the group consisting of polyurethanes, polyureas, polyamides, polyesters, polycarbonates, urea-formaldehyde resins, melamine resins, polystyrene, styrenemethacrylate copolymers, styrene-acrylate copolymers, gelatin, polyvinyl pyrrolidone and polyvinyl alcohols.

11. The process of claim 10, wherein said microcapsule wall is made of at least one member selected from the group consisting of polyurethanes, polyureas, polyamides, polyesters and polycarbonates.

12. The process of claim 11, wherein said microcapsule wall is made of at least one member selected from the group consisting of polyurethanes and polyurea.

13. The process of claim 1, wherein the particle size of said microcapsules is 0.01 to 30 $\mu$m.

14. The process of claim 13, wherein the particle size of said microcapsules is 0.01 to 10 $\mu$m.

15. The process of claim 14, wherein the particle size of said microcapsules is 0.01 to 5 $\mu$m.

## Revendications

1. Un procédé pour fabriquer une plaque d'impression lithographique qui comprend les étapes suivantes :
on applique sur une surface hydrophile d'un support une couche contenant des microcapsules contenant chacune un monomère photopolymérisable et/ou une résine photosensible, encapsulés dans une paroi hydrophile,
on imprime thermiquement la surface de la couche appliquée, les parois de microcapsules dans les zones thermiquement imprimées étant ramollies et les parois et le contenu des microcapsules étant fondus et mélangés pour former un film lipophile dans les zones de l'image thermiquement imprimée et ensuite on soumet la surface de la couche appliquée à l'exposition de toute la surface, le monomère photopolymérisable et/ou la résine photosensible contenus dans les microcapsules dans les zones ne formant pas l'image étant polymérisé ou durcie.

2. Le procédé selon la revendication 1, caractérisé en ce que ladite couche contenant des microcapsules contient un liant.

3. Le procédé selon la revendication 2, caractérisé en ce que ledit liant est hydrophile.

4. Le procédé selon la revendication 1, caractérisé en ce que l'on applique sur un support une couche contenant des microcapsules qui contiennent un monomère photopolymérisable et/ou une résine photosensible et un liant hydrophile, on imprime thermiquement la surface de la couche appliquée, on soumet la surface à l'exposition de toute la surface et on sépare la couche qui contient à la fois les microcapsules photodurcies et le liant hydrophile sur une machine d'impression.

5. Le procédé selon la revendication 1, caractérisé en ce que ledit monomère photopolymérisable est un composé ayant au moins un groupe vinyle ou vinylidène choisi parmi un groupe acryloyle, un groupe méthacryloyle, un groupe allyle, un groupe polyester insaturé, un groupe vinyloxy et un groupe acrylamido.

6. Le procédé selon la revendication 1, caractérisé en ce que lesdites microcapsules contiennent un inducteur de photopolymérisation capable d'absorber la lumière de l'ultraviolet au visible et d'amorcer la polymérisation du monomère photopolymérisable.

7. Le procédé selon la revendication 1, caractérisé en ce que lesdites microcapsules contiennent en outre un agent colorant.

8. Le procédé selon la revendication 7, caractérisé en ce que lesdites microcapsules contiennent en outre un précurseur de colorant.

9. Le procédé selon la revendication 1, caractérisé en ce que lesdites microcapsules contiennent en outre un agent auxiliaire de décomposition thermique.

10. Le procédé selon la revendication 1, caractérisé en ce que la paroi desdites microcapsules est faite d'au moins un composé choisi parmi les polyuréthannes, les polyurées, les polyamides, les polyesters, les polycarbonates, les résines urée-formaldéhyde, les résines de mélamine, le polystyrène, les copolymères styrène-méthacrylate, les copolymères styrène-acrylate, la gélatine, la polyvinylpyrrolidone et les alcools polyvinyliques.

11. Le procédé selon la revendication 10, caractérisé en ce que ladite paroi de microcapsules est faite d'au moins un composé choisi parmi les polyuréthannes, les polyurées, les polyamides, les polyesters et les polycarbonates.

12. Le procédé selon la revendication 11, caractérisé en ce que ladite paroi de microcapsules est faite d'au moins un composé choisi parmi les polyuréthannes et les polyurées.

13. Le procédé selon la revendication 1, caractérisé en ce que la dimension de particule desdites microcapsules est de 0,01 à 30 $\mu$m.

14. Le procédé selon la revendication 13, caractérisé en ce que la dimension de particule desdites microcapsules est de 0,01 à 10 $\mu$m.

15. Le procédé selon la revendication 14, caractérisé en ce que la dimension de particules desdites microcapsules est de 0,01 à 5 $\mu$m.

**Patentansprüche**

1. Verfahren zur Herstellung einer lithographischen Druckplatte, das die folgenden Stufen umfaßt:
Aufbringen einer Schicht, enthaltend Mikrokapseln, die jeweils Gehalte, enthaltend ein photopolymerisierbares Monomer und/oder ein lichtempfindliches Harz, und eine hydrophile Wand zum Einkapseln der Gehalte umfassen, auf eine hydrophile Oberfläche eines Trägers, thermisches Drucken der Oberfläche der aufgebrachten Schicht, wodurch die Mikrokapselwände in den thermisch gedruckten Bereichen erweicht werden und die Mikrokapselwände und die Gehalte geschmolzen und gemischt werden zur Bildung eines lipophilen Films in den thermisch gedruckten Bildbereichen, und anschließendes Aussetzen der Oberfläche der aufgebrachten Schicht einer Gesamtoberflächenbelichtung, wodurch das photopoymerisierbare Monomer und/oder das lichtempfindliche Harz, die in den Mikrokapseln in Nichtbildbereichen enthalten sind, polymerisiert oder gehärtet wird.

2. Verfahren nach Anspruch 1, worin die mikrokapselhaltige Schicht ein Bindemittel enthält.

3. Verfahren nach Anspruch 2, worin das Bindemittel hydrophil ist.

4. Verfahren nach Anspruch 1, das das Aufbringen einer Schicht, enthaltend Mikrokapseln, die ein photopoymerisierbares Monomer und/oder ein lichtempfindliches Harz enthalten, und ein hydrophiles Bindemittel, auf einen Träger, das thermische Drucken der Oberfläche der aufgebrachten Schicht, das Aussetzen der Oberfläche einer Gesamtoberflächenbelichtung und das Entfernen der Schicht, die sowohl die lichtgehärteten Mikrokapseln als auch das hydrophile Bindemittel enthält, auf einer Druckmaschine umfaßt.

5. Verfahren nach Anspruch 1, worin das photopolymerisierbare Monomer eine Verbindung mit wenigstens einer Vinyl- oder Vinylidengruppe, gewählt aus der Gruppe, bestehend aus einer Acryloylgruppe, einer Methacryloylgruppe, einer Allylgruppe, einer ungesättigten Poyestergruppe, einer Vinyloxygruppe und einer Acrylamidogruppe, ist.

6. Verfahren nach Anspruch 1, worin die Mikrokapseln einen Photopolymerisationsinitiator, der Licht im ultravioletten bis sichtbaren Bereich absorbieren kann und die Polymerisation des photopoymerisierbaren Monomers initiiert, enthalten.

7. Verfahren nach Anspruch 1, worin die Mikrokapseln weiterhin ein Färbungsmittel enthalten.

8. Verfahren nach Anspruch 7, worin die Mikrokapseln weiterhin einen Farbvorläufer enthalten.

9. Verfahren nach Anspruch 1, worin die Mikrokapseln weiterhin ein Hilfsmittel zur thermischen Zersetzung enthalten.

10. Verfahren nach Anspruch 1, worin die Wand der Mikrokapseln aus wenigstens einem Teil, gewählt aus der Gruppe, bestehend aus Polyurethanen, Polyharnstoffen, Polyamiden, Polyestern, Polycarbonaten, Harnstoff-Formaldehydharzen, Melaminharzen, Polystyrol, Styrolmethacrylatcopolymeren, Stryrol-Acrylatcopolymeren, Gelatine, Polyvinylpyrrolidon und Polyvinylalkoholen, hergestellt ist.

11. Verfahren nach Anspruch 10, worin die Mikrokapselwand aus wenigstens einem Teil, gewählt aus der Gruppe, bestehend aus Polyurethanen, Polyharnstoffen, Polyamiden, Polyestern und Polycarbonaten, hergestellt ist.

12. Verfahren nach Anspruch 11, worin die Mikrokapselwand aus wenigstens einem Teil, gewählt aus der Gruppe, bestehend aus Polyurethanen und Polyharnstoff, hergestellt ist.

13. Verfahren nach Anspruch 1, worin die Teilchengröße der Mikrokapseln 0,01 bis 30 $\mu$m beträgt.

14. Verfahren nach Anspruch 13, worin die Teilchengröße der Mikrokapseln 0,01 bis 10 $\mu$m beträgt.

15. Verfahren nach Anspruch 14, worin die Teilchengröße der Mikrokapseln 0,01 bis 5 $\mu$m beträgt.